# EUROPEAN PATENT SPECIFICATION

(11) **EP 4 216 291 B1**
(45) Date of publication and mention of the grant of the patent: **25.11.2026**
(21) Application number: 23151908.3
(22) Date of filing: 17.01.2023
(51) Int. Cl.: H10H 20/812, H10H 20/816, H10H 20/825, H10H 20/811, H10H 20/821

(54) **LIGHT EMITTING ELEMENT AND METHOD OF MANUFACTURING SAME**
LICHTEMITTIERENDES ELEMENT UND VERFAHREN ZU SEINER HERSTELLUNG
ÉLÉMENT ÉLECTROLUMINESCENT ET SON PROCÉDÉ DE FABRICATION

(30) Priority: 19.01.2022 JP 2022006580; 15.09.2022 JP 2022147283
(43) Date of publication of application: 26.07.2023
(73) Proprietor: Nichia Corporation, Anan-shi, Tokushima 774-8601 (JP)
(72) Inventor: ASADA, Koji, Tokushima, 774-8601 (JP); OKADA, Takuya, Tokushima, 774-8601 (JP)
(74) Representative: Betten & Resch

(56) References cited:
- EP-A1- 2 843 714
- US-A1- 2013 037 779
- US-A1- 2015 263 232
- US-B2- 10 490 695

## Description

### CROSS-REFERENCE TO RELATED APPLICATION

This application claims priority to Japanese Patent Application No. 2022-006580, filed on January 19, 2022, and Japanese Patent Application No. 2022-147283, filed on September 15, 2022.

### BACKGROUND

The present invention relates to a light emitting element and a method of manufacturing the light emitting element.

Japanese Patent Publication No. 2019-54122 describes a deep ultraviolet light emitting element comprising a plurality of nitride semiconductor layers. There is a need to improve the light extraction efficiency of such a light emitting element.

US 2015/263232 Al discloses an optical semiconductor element which includes a first nitride semiconductor layer of a first conductivity type, a second nitride semiconductor layer of a second conductivity type, and an active layer provided between the first nitride semiconductor layer and the second nitride semiconductor layer.

US 2013/037779 A1 discloses a nitride semiconductor light-emitting device which includes an n-type nitride semiconductor layer, a V pit generation layer, an intermediate layer, a multiple quantum well light-emitting layer, and a p-type nitride semiconductor layer provided in this order.

### SUMMARY

The present invention is defined by the independent claims. Dependent claims specify embodiments thereof.

An object of an embodiment of the present invention is to provide a high light extraction efficiency light emitting element and a method of manufacturing the light emitting element.

A light emitting element according to one embodiment of the present invention comprises: a semiconductor structure comprising an n-side layer, a p-side layer, and an active layer configured to emit ultraviolet light positioned between the n-side layer and the p-side layer, each being made of a nitride semiconductor; an n-electrode electrically connected to the n-side layer; and a p-electrode electrically connected to the p-side layer. The active layer comprises a well layer containing Al, a barrier layer containing Al, and holes defined by lateral faces of the well layer and lateral faces of the barrier layer. The p-side layer comprises a first layer containing Al, a second layer containing Al disposed on the first layer and in contact with the lateral faces of the well layer, and a third layer disposed on the second layer. A thickness of the third layer is less than a thickness of the first layer. An Al composition ratio of the second layer differs from an Al composition ratio of the well layer by 10% or less. An Al composition ratio of the third layer is less than an Al composition ratio of the second layer, or the third layer contains no Al. The p-electrode is disposed on the third layer.

A method of manufacturing a light emitting element according to one embodiment of the present invention comprises forming an n-side layer made of a nitride semiconductor; forming, on the n-side layer, an active layer configured to emit ultraviolet light and comprising a well layer containing Al and a barrier layer containing Al, each being made of a nitride semiconductor, and holes defined by lateral faces of the well layer and lateral faces of the barrier layer; forming, on the active layer, a p-side layer comprising a first layer containing Al, a second layer containing Al, and a third layer, each being made of a nitride semiconductor, wherein an Al composition ratio of the second layer differs from an Al composition ratio of the well layer by 10% or less, wherein a thickness of the third layer is less than a thickness of the first layer, wherein an Al composition ratio of the third layer is less than an Al composition ratio of the second layer, or the third layer contains no Al, and wherein the step of forming the p-side layer comprises: forming the first layer on the active layer, forming the second layer on the first layer and in contact with the lateral faces of the well layer, and forming the third layer on the second layer; forming an n-electrode electrically connected to the n-side layer; and forming a p-electrode electrically connected to the third layer of the p-side layer.

According to certain embodiments of the present invention, a high light extraction efficiency light emitting element and a method of manufacturing the light emitting element can be provided.

### BRIEF DESCRIPTION OF THE DRAWINGS

FIG. 1 is a schematic cross-sectional view showing the constituents of a light emitting element according to an embodiment of the present invention.
FIG. 2 is a schematic cross-sectional view showing the constituents of the light emitting element of the embodiment of the present invention.
FIG. 3 is a schematic cross-sectional view showing the constituents of a light emitting element in a variation of the embodiment of the present invention.
FIG. 4 is a schematic cross-sectional view explaining a method of manufacturing a light emitting element according to one embodiment of the present invention.
FIG. 5 is a schematic cross-sectional view explaining the method of manufacturing a light emitting element according to the embodiment of the present invention.
FIG. 6 is a schematic cross-sectional view explaining the method of manufacturing a light emitting element according to the embodiment of the present invention.
FIG. 7 is a schematic cross-sectional view explaining the method of manufacturing a light emitting element according to the embodiment of the present invention.
FIG. 8 is a schematic cross-sectional view explaining the method of manufacturing a light emitting element according to the embodiment of the present invention.
FIG. 9 is a schematic cross-sectional view explaining the method of manufacturing a light emitting element according to the embodiment of the present invention.
FIG. 10 is a schematic cross-sectional view explaining the method of manufacturing a light emitting element according to the embodiment of the present invention.

### DETAILED DESCRIPTION

Certain embodiments of the present invention will be explained below. The drawings referenced in the following description are schematic representations of the present invention. Therefore, the scale, spacing, or positional relationships of members might be exaggerated, or a certain portion of a member omitted. In the description below, the same reference numerals are used to denote the same members or those of similar quality for which detailed explanation might be omitted as appropriate.

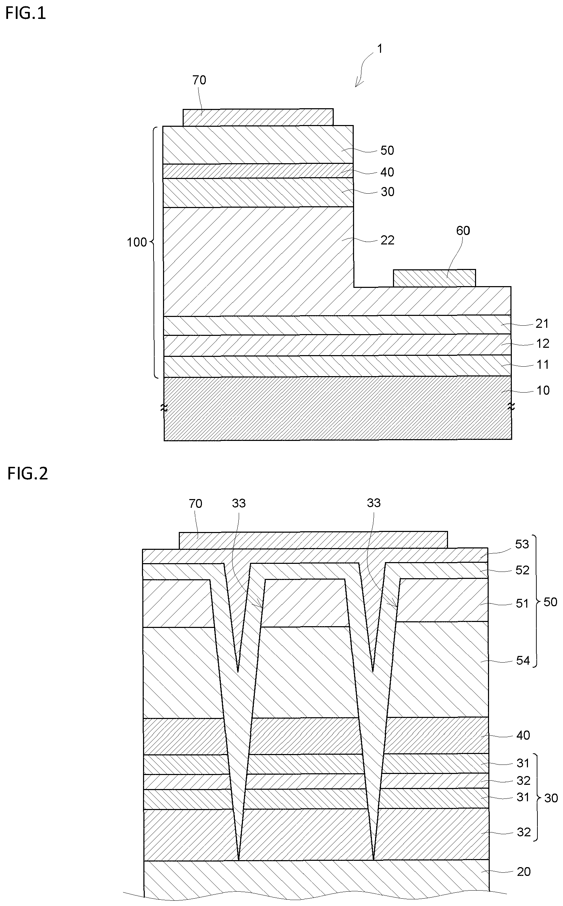

FIG. 1 is a schematic cross-sectional view of a light emitting element 1. FIG. 2 is a schematic cross-sectional view enlarging a portion of a semiconductor structure 100. As shown in FIGS. 1 and 2, the light emitting element 1 has a substrate 10 and a semiconductor structure 100 disposed on the substrate 10. The semiconductor structure 100 includes an n-side layer 20, a p-side layer 50, and an ultraviolet light emitting active layer 30 positioned between the n-side layer and the p-side layer, each being made of a nitride semiconductor. The semiconductor structure 100 further includes a buffer layer 11 and a superlattice layer 12 positioned between the substrate 10 and the n-side layer 20, and an electron blocking layer 40 positioned between the active layer 30 and the p-side layer 50. The light emitting element 1 has an n-electrode 60 electrically connected to the n-side layer 20 and a p-electrode 70 electrically connected to the p-side layer 50.

For the material of the substrate 10, for example, sapphire, silicon (Si), gallium nitride (GaN), aluminum nitride (AlN), or the like can be used. A substrate 10 made of sapphire is preferable as it has a high transmittance with respect to the ultraviolet light from the active layer 30. The semiconductor structure 100 can be disposed, for example, on C-plane of the sapphire substrate, and is preferably disposed on a face oblique to the C-plane of the sapphire substrate forming a 0.2 to 2 degree angle with the a-axis or the m-axis of the sapphire substrate. The thickness of the substrate 10 can be set, for example, in a range of 150 *µ*m to 800 µm. The light emitting element 1 does not have to have a substrate 10.

The semiconductor structure 100 is a stack structure in which nitride semiconductor layers are stacked. Nitride semiconductors can include all semiconductors obtained by varying the composition ratio x and y within their ranges in the chemical formula InₓAl_{y}Ga_{1-x-y}N (0≤x≤1, 0≤y≤1, x+y≤1).

For the buffer layer 11, for example, an AlN layer can be used. The buffer layer 11 has the function of reducing the lattice mismatch between the substrate 10 and the nitride semiconductor layers disposed on the buffer layer 11. The thickness of the buffer layer 11 can be set, for example, in a range of 0.5 *µ*m to 4 *µ*m, more preferably 1.5 *µ*m to 4 *µ*m. In the present specification, the thickness of each semiconductor layer refers to the thickness in the stacking direction of the semiconductor structure 100.

A superlattice layer 12 has a multilayer structure in which first semiconductor layers and second semiconductor layers having a different lattice constant from that of the first semiconductor layers are alternately formed. The superlattice layer 12 has the function of reducing the stress occurring in the semiconductor layers disposed above the superlattice layer 12. The superlattice layer 12 can be a multilayer structure in which AlN layers and aluminum gallium nitride (AlGaN) layers are alternately stacked, for example. The number of pairs of first and second semiconductor layers in the superlattice layer 12 can be set in a range of 20 to 50 pairs. In the case in which the first semiconductor layers are AlGaN layers and the second semiconductor layers are AlN layers, the first semiconductor layers and the second semiconductor layers can each be in a range of 5 nm to 30 nm in thickness.

The n-side layer 20 includes one or more n-type semiconductor layers. Examples of n-type semiconductor layers include semiconductor layers containing an n-type impurity, such as silicon (Si), germanium (Ge), or the like. An n-type semiconductor layer is, for example, an AlGaN layer containing aluminum (Al), gallium (Ga), and nitrogen (N), and may contain indium (In). For example, the n-type impurity concentration of an n-type semiconductor layer containing Si as an n-type impurity is in a range of 5×10¹⁸ cm³ to 1×10²⁰ cm³. The n-side layer 20 has only to have the function of supplying electrons, and may include an undoped layer. Here, an undoped layer is a layer not intentionally doped with an n-type impurity or a p-type impurity. In the case where an undoped layer is adjacent to a layer intentionally doped with an n-type impurity and/or a p-type impurity, the undoped layer might contain the n-type impurity and/or the p-type impurity diffused from the adjacent layer.

As shown in FIG. 1, the n-side layer 20 includes an underlayer 21 and an n-contact layer 22. The underlayer 21 is disposed between the superlattice layer 12 and the n-contact layer 22. The n-contact layer 22 is disposed between the underlayer 21 and the active layer 30.

For an underlayer 21, for example, an undoped AlGaN layer can be used. In the case in which the underlayer 21 is an AlGaN layer, the Al composition ratio of the AlGaN layer can be set, for example, in a range of 50% or higher.

For an n-contact layer 22, for example, an AlGaN layer containing an n-type impurity can be used. In the case of using an AlGaN layer as the n-contact layer, the Al composition ratio of the AlGaN layer can be set, for example, in a range of 50% or higher. In the present specification, an AlGaN layer having an Al composition ratio of 50%, for example, means that the composition ratio x in the chemical formula Al_{X}Ga_{1-X}N is 0.5. The n-type impurity concentration of the n-contact layer 22 can be set, for example, in a range of 5× 10¹⁸ cm³ to 1×10²⁰ cm³. The n-contact layer 22 is larger in thickness than the underlayer 21. The thickness of the n-contact layer 22 can be set, for example, in a range of 1.5 *µ*m to 4 *µ*m. The n-contact layer 22 has an upper face on which no semiconductor layer is disposed. An n-electrode 60 is disposed on the upper face of the n-contact layer 22 on which no semiconductor layer is disposed.

The active layer 30 is disposed between an n-side layer 20 and a p-side layer 50. The active layer 30 emits ultraviolet light. The peak emission wavelength of the ultraviolet light emitted by the active layer 30 is, for example, 220 nm to 350 nm.

The active layer 30 has a well layer 31 containing Al, a barrier layer 32 containing Al, and holes defined by the lateral faces of the well layer 31 and the lateral faces of the barrier layer 32. The holes of the active layer 30 are, for example, V pits created during the formation of the active layer 30. The holes of the active layer 30 may be, for example, through holes that go through the active layer 30, or those having bottoms in the barrier layer 32. The active layer 30 has, for example, a multiple quantum well structure that includes a plurality of well layers 31 and a plurality of barrier layers 32. The Al composition ratio of a barrier layer 32 is higher than the Al composition ratio of a well layer 31. In other words, the band gap energy of a barrier layer 32 is larger than the band gap energy of a well layer 31. A well layer 31 containing Al emits light having the emission wavelength corresponding to the band gap energy of the well layer 31. The active layer 30 is not limited to a multiple quantum well structure that includes a plurality of well layers 31, and can be a single quantum well structure. Furthermore, the lowermost layer of the active layer 30 is a barrier layer 32 in FIG. 2, but the lowermost layer of the active layer 30 may be a well layer 31. The uppermost layer of the active layer 30 is a well layer 31 in FIG. 2, but the uppermost layer of the active layer 30 may be a barrier layer 32.

For a well layer 31, for example, an AlGaN layer can be used. For a barrier layer 32, for example, a AlGaN layer can be used. The Al composition ratio of a well layer 31 can be set, for example, in a range of 10% or higher, specifically 10% to 50%, more specifically 30% to 50%. In the case of allowing a well layer 31 to emit light having a peak emission wavelength of about 280 nm, an AlGaN layer having an Al composition ratio of about 42% can be used for the well layer 31. The Al composition ratio of a barrier layer 32 can be set, for example, in a range of 10% or higher, specifically 10% to 60%, more specifically 30% to 60%.

The thickness of a well layer 31 can be set, for example, in a range of 3 nm to 6 nm. The thickness of a barrier layer 32 is in a range of, for example, 2 nm to 4 nm. From the standpoint of increasing the volume of the semiconductor layer that contributes to light emission, the well layer 31 is preferably larger in thickness than the barrier layer 32. The thickness of the well layer 31 can be set as 1.5 to 2 times the thickness of the barrier layer 32. The well layer 31 and the barrier layer 32 may contain an n-type impurity and/or a p-type impurity at least in part.

A V pit 33 is formed continuously across the active layer 30, the electron blocking layer 40 and a portion of the p-side layer 50. In this embodiment, a V pit 33 is defined by the faces that include the lateral faces of the well layer 31, the lateral faces of the barrier layer 32, the lateral faces of the electron blocking layer 40, the lateral faces of the fourth layer 54, and the lateral faces of the first layer 51. A V pit 33 is formed during the formation of the semiconductor structure 100, and a recess is created on the surface of the semiconductor structure 100 corresponding to the part where the V pit 33 is located. The semiconductor structure 100 has a plurality of V pits 33. When viewed from above, the shape of a V pit 33 is, for example, circular, elliptical, or hexagonal. When viewed from above, the diameter of a V pit 33 is in a range of, for example, 30 nm to 100 nm. A V pit 33 is, for example, a cone, elliptical pyramid, or polygonal pyramid in which the diameter increases from the n-side layer 20 side to the p-side layer 50. V pits 33 are formed, for example, when a semiconductor structure 100 is epitaxially grown on a substrate 10.

The electron blocking layer 40 is disposed to reduce the overflow of electrons supplied from the n-side layer 20. The electron blocking layer 40 can be a multilayer structure having a plurality of semiconductor layers containing Al. The electron blocking layer 40 can be a multilayer structure including, for example, an AlN layer, a first AlGaN layer, and a second AlGaN layer successively from the active layer 30 side. The Al composition ratio of the first AlGaN layer is lower than the Al composition ratio of the second AlGaN layer, and higher than the Al composition ratio of the well layer 31. For the electron blocking layer 40, a semiconductor layer having a higher Al composition ratio than the Al composition ratio of the barrier layers is used. This can reduce the electron overflow. For the electron blocking layer 40, for example, an undoped AlGaN layer, undoped AlN layer, or the like can be used. The total thickness of the electron blocking layer 40 can be set, for example, in a range of 5 nm to 15 nm.

In general, in order to reduce the amount of light from the well layer 31 that is absorbed by a semiconductor layer to thereby increase the light extraction efficiency, a semiconductor layer having a high light transmittance with respect to the light from the well layer 31 is preferably used as a p-side layer 50. For example, using as a p-side layer 50 an AlGaN layer having a higher Al composition ratio than the Al composition ratio of the well layer 31 can make it difficult for the p-side layer 50 to absorb the light from the well layer 31. However, an AlGaN layer having a high Al composition ratio has larger band gap energy than a GaN layer or the like. For this reason, using an AlGaN layer having a high Al composition ratio as a p-side layer 50 results in inadequate conversion of the p-side layer 50 into a p-type layer or an increased contact resistance between the p-electrode 70 and the p-side layer 50. This makes it difficult for a light emitting element having a well layer made of AlGaN having a relatively high Al composition ratio to achieve both high light extraction efficiency and low forward voltage Vf. In this embodiment, providing the p-side layer 50 described below can produce a light emitting element 1 that has high emission efficiency and low forward voltage Vf.

The p-side layer 50 includes , in a light emitting element according to an example not forming part of the invention as claimed, one or , in accordance with the claimed invention, more p-type semiconductor layers. Examples of p-type semiconductor layers include those that contain a p-type impurity, such as magnesium (Mg) or the like. As shown in FIG. 2, the p-side layer 50 has, successively from the active layer 30 side, a first layer 51, a second layer 52, and a third layer 53. The p-side layer 50 further has a fourth layer 54 disposed between the electron blocking layer 40 and the first layer 51. The first layer 51 contains Al. The second layer contains Al and is disposed on the first layer 51 in contact with the lateral faces of the well layer 31. The third layer 53 is disposed on the second layer 52. The fourth layer 54 contains Al.

An Al composition ratio of the second layer differs from an Al composition ratio of the well layer by 10% or less. This allows the light from the lateral faces of the well layer 31 defining a V pit 33 to propagate to the second layer 52 disposed in contact with the lateral faces of the well layer 31, thereby facilitating the extraction of light through the p-side layer 50 while reducing the absorption of light by the second layer 52. This can achieve a high light extraction efficiency light emitting element 1.

A thickness of the third layer 53 is less than a thickness of the first layer 51. The third layer 53, furthermore, has a lower Al composition ratio than the Al composition ratio of the second layer 52, or contains no Al. The p-electrode 70 is disposed on the third layer 53. This can reduce the contact resistance between the p-electrode 70 and the third layer 53 while reducing the absorption of light by the third layer 53. This thus can reduce the forward voltage Vf while reducing the degradation of the light extraction efficiency.

As described above, according to this embodiment, a high light extraction efficiency light emitting element 1 can be achieved. Moreover, the forward voltage Vf of the light emitting element 1can be reduced.

The second layer 52 is continuously disposed from the upper face of the first layer 51 to the lateral faces of the fourth layer 54, the lateral faces of the electron blocking layer 40, the lateral faces of the well layer 31, and the lateral faces of the barrier layer 32. All of the lateral faces of the semiconductor layers defining the V pits 33 are covered by the second layer 52, and recesses corresponding to the V pits 33 are formed on the surface of the second layer 52. In order to bring the surface condition of the third layer 53 to be disposed on the second layer 52 close to being flat, the depths of the recesses formed at the surface of the second layer 52 are preferably less than the depths of the V pits 33 in a cross section. In this embodiment, as shown in FIG. 2, the upper surface of the second layer 52 is entirely covered by the third layer 53, but is not limited to this. For example, a portion of the upper face of the second layer 52 may be exposed from the third layer 53 to the extent that the contact resistance between the p-electrode 70 and the third layer 53 is not degraded.

The third layer 53 is preferably less in thickness than the second layer 52. For example, the thickness of the third layer 53 located above the first layer 51 is preferably equal to or less in thickness than the second layer 52. This can reduce the absorption of light by the third layer 53. The second layer 52 is preferably less in thickness than the first layer 51. This can reduce the absorption of light by the second layer 52.

The thickness of the first layer 51 can be set, for example, in a range of 20 nm to 40 nm. The thickness of the second layer 52 is preferably set, for example, in a range of 3 nm to 20 nm, more preferably 3 nm to 15 nm. Setting the thickness of the second layer 52 as 3 nm or greater can facilitate the filling of V pits 33. Setting the thickness of the second layer 52 as 20 nm or less can reduce the absorption of light by the second layer 52. The thickness of the third layer 53 is preferably set, for example, in a range of 3 nm to 20 nm, more preferably 3 nm to 15 nm. Setting the thickness of the third layer 53 as 3 nm or greater can increase the effect of reducing the contact resistance between the p-electrode 70 and the third layer 53 more easily. Setting the thickness of the third layer 53 as 20 nm or less can reduce the absorption of light by the third layer 53.

The first layer 51, the second layer 52, and the third layer 53 contain a p-type impurity. The second layer 52 and the third layer 53 preferably have a higher p-type impurity concentration than the p-type impurity concentration of the first layer 51. Allowing the layers in the vicinity of the third layer 53 on which the p-electrode 70 is disposed to have a high p-type impurity concentration can facilitate the supply of holes from the p-side layer 50 to the active layer 30, thereby increasing the emission efficiency of the light emitting element 1.

The p-type impurity concentration of the third layer 53 is preferably higher than the p-type impurity concentration of the second layer 52. Allowing the third layer 53 on which the p-electrode 70 is disposed to have a high p-type impurity concentration can facilitate the supply of holes from the p-side layer 50 to the active layer 30, thereby increasing the emission efficiency of the light emitting element 1. The p-type impurity concentration of the third layer 53 is higher than the p-type impurity concentration of the fourth layer 54.

The p-type impurity concentrations of the first layer 51, the second layer 52, the third layer 53, and the fourth layer 54 are in a range of, for example, 1×10¹⁹ cm³ to 1×10²¹ cm³.

The Al composition ratio of the first layer 51 is preferably higher than the Al composition ratio of the second layer 52. The light extraction efficiency can be increased by setting a higher Al composition ratio for the first layer 51, which is positioned closer to the active layer 30 than the second layer 52 is, to reduce the light absorption by the first layer 51.

The first layer 51 may be a composition gradient layer in which the Al composition ratio decreases from the active layer 30 side to the second layer 52 side. This can reduce the portion of the first layer 51 that has a high Al composition ratio to thereby reduce the forward voltage Vf as compared to the case in which the first layer 51 is a semiconductor layer having a constant Al composition ratio. For example, the Al composition ratio difference between the portion of the first layer 51 positioned on the active layer 30 side and the portion of the first layer 51 positioned on the second layer 52 side can be set in a range of 20% to 60%. Specifically, the Al composition ratio of the portion of the composition gradient layer positioned on the active layer 30 side can be set in a range of 40% to 70%, and the Al composition ratio of the portion of the composition gradient layer positioned on the second layer 52 side can be set in a range of 0% to 20%. Furthermore, a portion of the first layer 51 may be a composition gradient layer in which the Al composition ratio decreases. This can reduce the high Al composition ratio portion of the first layer 51 to thereby reduce the forward voltage Vf as compared to the case in which the entire first layer 51 is a composition gradient layer. For example, only the portion of the first layer 51 that is positioned on the second layer 52 side can be a composition gradient layer. The composition gradient portion of the first layer 51 can have a thickness of 3% to 20% of the thickness of the first layer 51. The composition gradient portion of the first layer 51 can have a thickness, for example, in a range of 1 nm to 30 nm.

The Al composition ratio of the second layer 52 is preferably higher than the Al composition ratio of a well layer 31. This can further reduce the amount of light absorbed by the second layer 52 while facilitating the propagation of the light from the lateral faces of the well layer 31 through the second layer 52 thereby increasing the light extraction efficiency.

The Al composition ratio of the first layer 51 is preferably set, for example, in a range of 50% to 70%, more preferably 50% to 60%. The Al composition ratio of the second layer 52 is preferably set, for example, in a range of 30% to 60%, more preferably 35% to 55%, even more preferably 40% to 55%. Setting the Al composition ratio of the second layer 52 to 30% or higher can reduce the amount of light absorbed by the second layer 52. Setting the Al composition ratio of the second layer 52 to 60% or less can reduce the bulk resistance of the second layer 52 to thereby reduce the degradation of the forward voltage Vf. The Al composition ratio of the third layer 53 is preferably set, for example, to 3% or less. This can promote the conversion of the third layer 53 into a p-type layer to further improve the emission efficiency.

The first layer 51 is made of aluminum gallium nitride, for example. The second layer 52 is made of aluminum gallium nitride, for example. The third layer 53 is made of gallium nitride or aluminum gallium nitride, for example. The fourth layer 54 is made of aluminum gallium nitride, for example. The first layer 51, the second layer 52, the third layer 53, and the fourth layer 54 may contain In.

The fourth layer 54 is larger in thickness than the third layer 53. The thickness of the fourth layer 54 can be set, for example, to 60 nm to 100 nm. The Al composition ratio of the fourth layer 54 is higher than the Al composition ratio of the first layer 51, and lower than the Al composition ratio of the semiconductor layer of the electron blocking layer 40 in contact with the fourth layer 54 (the second AlGaN layer). This can facilitate the supply of holes from the p-electrode 70 side to the active layer 30. The Al composition ratio of the fourth layer 54 is preferably set, for example, in a range of 50% to 70%, more preferably 60% to 70%.

An n-electrode 60 is disposed on the n-contact layer 22 and electrically connected to the n-side layer 20. An p-electrode 70 is disposed on the third layer 53 and electrically connected to the p-side layer 50.

For an n-electrode 60, for example, metals, such as Ag, Al, Ni, Au, Rh, Ti, Pt, Mo, Ta, W, and Ru, or alloys having these metals as main components can be used. The n-electrode 60 can be, for example, a multilayer structure including, successively from the n-contact layer 22 side, a Ti layer, an Al alloy layer, a Ta layer, and an Ru layer.

For a p-electrode 70, for example, a similar metal to that for the n-electrode 60 described above can be used. In the case in which the p-electrode 70 has the function of reflecting the light approaching the p-electrode 70 towards the n-side layer 20, the metal layer of the p-electrode 70 provided in contact with the third layer 53 is preferably a metal layer having a high reflectance with respect to the light from the active layer 30. For example, a metal layer having a reflectance of 70% or higher, preferably 80% or higher with respect to the light from the active layer 30 is preferably used. For such a metal layer, for example, an Rh layer or Ru layer is preferably used. The p-electrode 70 can be a multilayer structure that includes an Rh layer, an Au layer, an Ni layer, and a Ti layer, for example, or a multilayer structure that includes an Ru layer, an Au layer, an Ni layer, and a Ti layer.

When a forward voltage is applied across the n-electrode 60 and the p-electrode 70, a forward voltage applies across the p-side layer 50 and the n-side layer 20, supplying holes and electrons to the active layer 30 to thereby allow the active layer 30 to emit light.

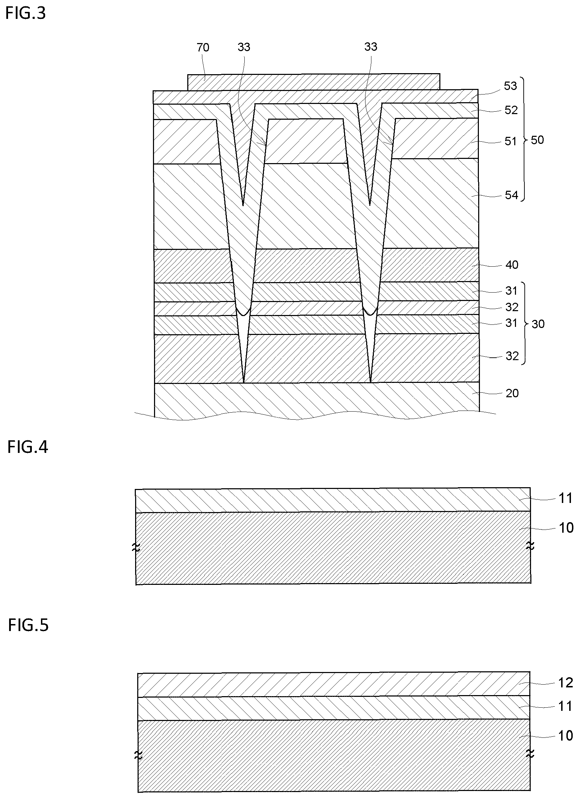

In this embodiment, as shown in FIG. 2, the second layer 52 is in contact with the lateral faces of two well layers 31, but is not limited to this. FIG. 3 is a schematic cross-sectional view of a variation of this embodiment. As shown in FIG. 3, in the case in which an active layer 30 includes a plurality of well layers 31, the second layer 52 can simply be in contact with at least the lateral faces of the well layer 31 positioned closest to the p-side layer 50 among all well layers 31. As shown in FIG. 3, the lateral faces of the well layer 31 positioned on the n-side layer 20 side among the well layers 31 are exposed from the second layer 52. The well layer 31 positioned closest to the p-side layer 50 among the well layers 31 tends to emit light more intensely than the other well layers 31. Accordingly, disposing the second layer 52 to be in contact with the lateral faces of at least the well layer 31 positioned closest to the p-side layer 50 among the well layers 31 can efficiently achieve the effect of increasing the light extraction efficiency described above.

A method of manufacturing a light emitting element according to this embodiment will be explained below with reference to FIG. 4 to FIG. 10.

A method of manufacturing a light emitting element according to this embodiment includes a step of forming an n-side layer 20 made of a nitride semiconductor layer, a step of forming an active layer 30 on the n-side layer 20, a step of forming a p-side layer 50 on the active layer 30, a step of forming an n-electrode 60 electrically connected to the n-side layer 20, and a step of forming a p-electrode 70 electrically connected to the p-side layer 50. The step of forming a p-side layer 50 includes a step of forming a first layer 51 on the active layer 30, a step of forming a second layer 52 in contact with the upper face of the first layer 51 and the lateral faces of the well layer 31, and a step of forming a third layer 53 on the second layer 52.

First, as shown in FIG. 4, a step of forming a buffer layer 11 made of AlN on C-plane of a substrate 10 made of sapphire, for example, is performed. The buffer layer 11 is formed by metal-organic chemical vapor deposition (MOCVD), for example. Each of the semiconductor layers described below can be epitaxially grown by MOCVD, for example.

Next, as shown in FIG. 5, a step of forming a superlattice layer 12 on the buffer layer 11 is performed. The superlattice layer 12 is formed by alternately growing first semiconductor layers and second semiconductor layers having a different lattice constant from that of the first semiconductor layers. The first semiconductor layers are formed by growing AlN layers, for example, by using trimethyl aluminum (TMA) gas and ammonia gas as source gases, and primarily hydrogen (H₂) gas as a carrier gas. The second semiconductor layers are formed by growing AlGaN layers, for example, by using TMA gas, trimethyl gallium (TMG) gas, and ammonia gas as source gases, and primarily hydrogen (H₂) gas as a carrier gas. Each layer of the superlattice layer 12 can be formed by setting the temperature, for example, at 1000°C to 1250°C.

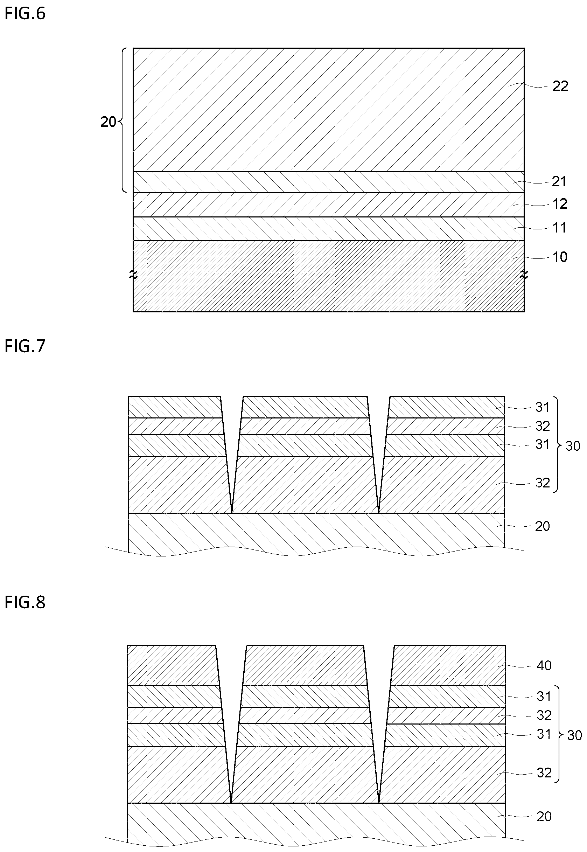

Then as shown in FIG. 6, a step of forming on the superlattice layer 12 an n-side layer 20 that includes an underlayer 21 and an n-contact layer 22 is performed. The underlayer 21 is formed by growing an AlGaN layer, for example, by using TMA gas, TMG gas, and ammonium gas as source gases, and primarily hydrogen gas as a carrier gas. The n-contact layer 22 is formed by growing an AlGaN layer containing an n-type impurity, for example, by using TMA gas, TMG gas, and ammonium gas as source gases, as well as monosilane (SiH₄) gas as an n-type impurity gas, and primarily hydrogen gas as a carrier gas. Each layer of the n-side layer 20 can be formed by setting the temperature, for example, at 1000°C to 1250°C.

Next, as shown in FIG. 7, a step of forming on the n-side layer 20 an active layer 30 that includes well layers 31 and barrier layers 32 is performed. The well layers 31 are formed by growing AlGaN layers, for example, by using TMA gas, TMG gas, and ammonium gas as source gases, and primarily nitrogen gas as a carrier gas. The barrier layers 32 are formed by growing AlGaN layers, for example, by using TMA gas, TMG gas, and ammonium gas as source gases, and primarily nitrogen gas as a carrier gas. An active layer 30 including a plurality of well layers 31 and a plurality of barrier layers 32 is formed by alternately growing the well layers 31 and the barrier layer 31, for example. In the step of forming a barrier layer 32, SiH₄ gas can be used as an n-type impurity gas to allow the layer to contain an n-type impurity. Each layer of the active layer 30 can be formed by setting the temperature, for example, at 850°C to 1050°C.

As shown in FIG. 7, a step of forming an active layer creates an active layer 30 that has holes defined by the lateral faces of multiple well layers 31 and the lateral faces of multiple barrier layers 32. In the step of forming an active layer, a carrier gas practically free of hydrogen gas is preferably used. This makes it easier to keep the holes unfilled to thereby form an active layer 30 in the state of exposing the lateral faces of the well layers 31.

Then as shown in FIG. 8, a step of forming an electron blocking layer 40 on the active layer 30 is performed. The electron blocking layer 40 is formed to include an AIN layer, a first AlGaN layer, and a second AlGaN layer. The AlN layer of the electron blocking layer 40 is formed by using, for example, TMA gas and ammonia gas as source gases, and primarily nitrogen gas as a carrier gas. The first AlGaN layer of the electron blocking layer 40 is formed by using, for example, TMA gas, TMG gas, and ammonia gas as source gases, and nitrogen gas as a carrier gas. The second AlGaN layer of the electron blocking layer 40 is formed by using, for example, TMA gas, TMG gas, and ammonia gas as source gases, and primarily nitrogen gas as a carrier gas. For example, in the step of forming a second AlGaN layer, the flow ratio of the TMA gas, which is an Al source gas, is set higher than the flow ratio of the TMA gas in the step of forming a first AlGaN layer. In this manner, the second AlGaN layer having a higher Al composition ratio than that of the first AlGaN layer can be formed. Each layer of the electron blocking layer 40 can be formed by setting the temperature, for example, at 750°C to 950°C.

As shown in FIG. 8, the electron blocking layer 40 is formed on the active layer 30 where the holes are absent so as not to fill the holes in the active layer 30. In the step of forming an electron blocking layer 40, it is preferable to use a carrier gas that contains practically no hydrogen gas. This makes it difficult to fill the holes in the active layer 30, thereby easily forming the electron blocking layer 40 while exposing the lateral faces of the well layers 31 from the electron blocking layer 40.

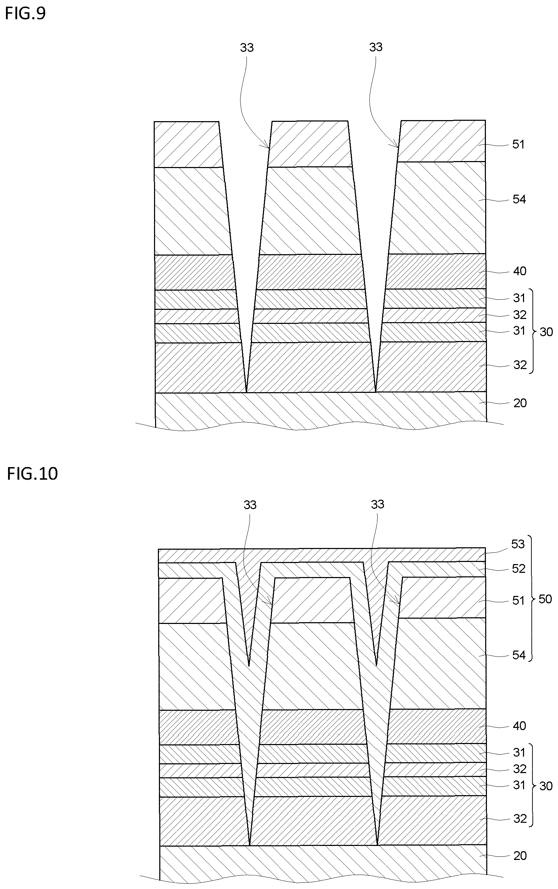

Next, as shown in FIG. 9 and FIG. 10, a step of forming a p-side layer 50 on the electron blocking layer 40 is performed. The p-side layer 50 is formed by growing successively from the active layer 30 side a fourth layer 54, a first layer 51, a second layer 52, and a third layer 53. The first layer 51, the second layer 52, the third layer 53, and the fourth layer 54 are each formed by growing an AlGaN layer containing Mg as a p-type impurity by using, for example, TMA gas, TMG gas, and ammonia gas as source gases, and cyclopentadienyl magnesium (Cp₂Mg) gas as a p-type impurity gas. Each layer of the p-side layer 50 can be formed by setting the temperature, for example, at 750°C to 950°C.

As shown in FIG. 9, the fourth layer 54 is formed on the electron blocking layer 40 that is not provided in the holes of the active layer 30 so as to be absent in the holes in the active layer 30. In the step of forming a fourth layer 54, a practically hydrogen-free carrier gas is preferably used. This makes it difficult to fill the holes in the active layer 30, thereby easily forming the fourth layer 54 while exposing the lateral faces of the well layers 31 from the fourth layer 54.

As shown in FIG. 9, the first layer 51 is formed on the fourth layer 54 that is not provided in the holes of the active layer 30 so as to be absent in the holes in the active layer 30. Similar to the step of forming a fourth layer 54, in the step of forming a first layer 51, a practically hydrogen-free carrier gas is preferably used. This makes it difficult to fill the holes in the active layer 30, thereby easily forming the first layer 51 while exposing the lateral faces of the well layers 31 from the first layer 51.

As shown in FIG. 10, in the step of forming a second layer 52, the second layer 52 is formed so as to be in contact with the lateral faces of the well layers 31, thereby filling the V pits 33. The growth rate in forming the second layer 52 is preferably set lower than the growth rate in forming the first layer 51. For example, the growth rate can be reduced by using a lower flow ratio of ammonia gas that is a source gas used in forming the second layer 52 than the flow ratio of ammonia gas that is a source gas used in forming the first layer 51. This makes it easier for the second layer 52 to fill the V pits 33, thereby facilitating the formation of the second layer 52 in contact with the lateral faces of the well layers 31. This can also bring the surface condition of the upper face of the second layer 52 on which a third layer 53 will be formed close to being flat, thereby improving the crystalline quality of the third layer 53.

The growth rate in forming the third layer 53 is preferably set lower than the growth rate in forming the first layer 51. For example, the growth rate can be reduced by using a lower flow ratio of ammonia gas that is a source gas used in forming the third layer 53 than the flow ratio of ammonia gas that is a source gas used in forming the first layer 51. This can bring the surface condition of the upper face of the third layer 53 closer to being flat than the upper face of the second layer 52. This, as a result, can facilitate the electrical connection between the third layer 53 and the p-electrode 70 to thereby reduce the forward voltage Vf.

The p-type impurity gas flow ratio in forming the second layer 52 is preferably set higher than the p-type impurity gas flow ratio in the step of forming a first layer 51. This allows the second layer 52 to fill the V pits 33 more easily such that the second layer 52 can be formed in contact with the lateral faces of the well layers 31.

The p-type impurity gas flow ratio in forming the third layer 53 is preferably set higher than the p-type impurity gas flow ratio in the step of forming a first layer 51. This can bring the surface condition of the upper face of the third layer 53 closer to being flat than the upper face of the second layer 52.

Subsequent to forming each semiconductor layer, a heat treatment is conducted in a nitrogen atmosphere in the reaction chamber at a temperature ranging from 400°C to 550°C, for example.

Subsequent to the heat treatment, a portion of the p-side layer 50, a portion of the electron blocking layer 40, and a portion of the active layer 30 are removed to expose a portion of the n-contact layer 22.

Then as shown in FIG. 1, an n-electrode 60 is formed on the exposed n-contact layer 22, and a p-electrode 70 is formed on the third layer 53 of the p-side layer 50.

By following the steps described above, a light emitting element of this embodiment can be produced.

Light emitting elements in Examples 1, 2, and Reference Example will be explained below.

### Example 1

As the substrate 10, a sapphire substrate having C-plane as a principal plane was used. On the substrate 10, a buffer layer 11 made of AlN was formed to a thickness of 2 *µ*m.

The temperature was then set at 1175°C, and an Al_{0.60}Ga_{0.40}N layer was formed on the buffer layer 11 to a thickness of about 21 nm by using TMA gas, TMG gas, and ammonia gas as source gases. This was followed by forming an AlN layer at 1175°C to a thickness of about 10 nm by using TMA gas and ammonia gas as source gases. A superlattice layer 12 was formed by stacking 30 pairs of such AlGaN and AlN layers.

Then at 1175°C, an underlayer 21 was formed on the superlattice layer 12 by growing Al_{0.60}Ga_{0.40}N to a thickness of about 0.5 *µ*m by using TMA gas, TMG gas, and ammonia gas as source gases. This was followed by forming an n-contact layer 22 at 1175°C by growing Al_{0.60}Ga_{0.40}N containing an n-type impurity to a thickness of about 2.2 *µ*m by using TMA gas, TMG gas, ammonia gas, and SiH₄ gas as source gases. An n-side layer 20 including such an underlayer 21 and n-contact layer 22 was formed. The n-type impurity concentration of the n-contact layer 22 was about 9.5×10¹⁸ cm³.

Next, the temperature was set at 950°C and a barrier layer 32 was formed on the n-side layer 20 by growing Al_{0.52}Ga_{0.48}N containing an n-type impurity to a thickness of about 50 nm by using TMA gas, TMG gas, ammonia gas, and SiH₄ gas as source gases. This was followed by forming a well layer 31 at 950°C by growing Al_{0.42}Ga_{0.58}N to a thickness of about 4.4 nm by using TMA gas, TMG gas, and ammonia gas as source gases. This was followed by forming a barrier layer 32 at 950°C by growing Al_{0.52}Ga_{0.48}N containing an n-type impurity to a thickness of about 2.5 nm by using TMA gas, TMG gas, ammonia gas, and SiH₄ gas as source gases. Then a well layer 31 was formed at 950°C by growing Al_{0.42}Ga_{0.58}N to a thickness of about 4.4 nm by using TMA gas, TMG gas, and ammonia gas as source gases. In this manner, an active layer 30, which included two well layers 31 and two barrier layers 32, was formed.

Next, the temperature was set at 870°C, and an AlN layer was formed on the active layer 30 to a thickness of about 1 nm by using TMA gas and ammonia gas as source gases. This was followed by forming a first AlGaN layer at 870°C by growing Al_{0.55}Ga_{0.45}N to a thickness of about 1 nm by using TMA gas, TMG gas, and ammonia gas as source gases. This was followed by forming a second AlGaN layer at 870°C by growing Al_{0.78}Ga_{0.22}N to a thickness of about 4 nm by using TMA gas, TMG gas, and ammonia gas as source gases. An electron blocking layer 40 that included such an AlN layer and two AlGaN layers was formed.

Then the temperature was set at 870°C, and a fourth layer 54 was formed on the electron blocking layer 40 by growing Al_{0.63}Ga_{0.37}N containing a p-type impurity to a thickness of about 78 nm by using TMA gas, TMG gas, ammonia gas, and Cp₂Mg gas as source gases. This was followed by forming a first layer 51 at 870°C by growing Al_{0.53}Ga_{0.47}N containing a p-type impurity to a thickness of about 30 nm by using TMA gas, TMG gas, ammonia gas, and Cp₂Mg gas as source gases. Then the temperature was set at 900°C, and a second layer 52 was formed by growing Al_{0.40}Ga_{0.60}N containing a p-type impurity to a thickness of about 10 nm by using TMA gas, TMG gas, ammonia gas, and Cp₂Mg gas as source gases. This was followed by forming a third layer 53 at 900°C by growing GaN containing a p-type impurity to a thickness of about 10 nm by using TMG gas, ammonia gas , and Cp2Mg gas as source gases. A p-side layer 50 that included such a first layer 51, second layer 52, third layer 53, and fourth layer 54 was formed. The ammonia gas flow ratio in the source gases in forming the second layer 52 and the third layer 53 was set lower than the ammonia gas flow ratio in forming the first layer 51. Furthermore, the Cp₂Mg gas flow ratio in the source gases in forming the second layer 52 and the third layer 53 was set higher than the Cp₂Mg gas flow ratio in the source gases in forming the first layer 51.

Subsequent to forming each semiconductor layer, a heat treatment was conducted in the reaction chamber. The heat treatment was performed in a nitrogen atmosphere at the temperature of about 475°C.

Subsequent to the heat treatment, a portion of the p-side layer 50 and a portion of the active layer 30 were removed to expose a portion of the n-side contact layer 22 from the p-side layer 50 and the active layer 30.

Then an n-electrode 60 was formed on the n-contact layer 22, and a p-electrode 70 was formed on the third layer 53 of the p-side layer 50. For the n-electrode 60, a multilayer structure in which a Ti layer, an AlSi layer, a Ta layer, an Ru layer, and a Ti layer were successively stacked from the n-contact layer 22 side was used. For the p-electrode 70, a multilayer structure in which a Ti layer, an Ru layer, and a Ti layer were successively stacked from the third layer 53 side was used.

Subsequently, the substrate 10 was divided into multiple light emitting elements. The outline of the substrate 10 of each light emitting element after being divided was a square each side being 1000 µm in length in a plan view. The substrate 10 of each light emitting element was 700 µm in thickness.

With respect to the light emitting element in Example 1 produced as described above, the forward voltage Vf was 5.86 V and the output Po was 182 mW. The forward voltage Vf and the output Po of each of Examples 1, 2 and Reference Example are the values obtained when a 350 mA current was applied.

### Example 2

The light emitting element in Example 2 was produced in a similar manner as in Example 1 except for using a different structure for the first layer 51.

For the light emitting element in Example 2, the first layer 51 was formed by growing an Al_{0.53}Ga_{0.47}N layer containing a p-type impurity to a thickness of about 27 nm and a composition gradient layer containing a p-type impurity to a thickness of about 3 nm. The composition gradient layer of the first layer 51 was formed to be located on the second layer 52 side. The composition gradient layer was formed such that the Al composition ratio decreased from the active layer 30 side to the second layer 52 side by reducing the TMA gas flow ratio. The composition gradient layer was formed such that the Al composition ratio decreased from about 53% to about 0% from the active layer 30 side to the second layer 52 side.

With respect to the light emitting element in Example 2 produced as described above, the forward voltage Vf was 5.13 V and the output Po was 161 mW.

### Reference Example

The light emitting element in Reference Example was produced in a similar manner as in Example 1 except for using a partially different structure for both the p-side layer 50 and the p-electrode 70.

For the light emitting element in Reference Example, the second layer 52 was formed by setting the temperature at 870°C and growing GaN containing a p-type impurity to a thickness of about 350 nm by using TMG gas, ammonia gas, and Cp₂Mg gas as source gases. Furthermore, the third layer 53 was formed at 870°C by growing GaN containing a p-type impurity to a thickness of about 20 nm by using TMG gas, ammonia gas, and Cp₂Mg gas as source gases. For the p-electrode 70, a multilayer structure in which a Ti layer, an Rh layer, and a Ti layer were successively stacked from the third layer 53 side was used.

With respect to the light emitting element in Reference Example produced as described above, the forward voltage Vf was 7.08 V and the output Po was 103 mW.

As is understood from the above, the light emitting elements in Examples 1 and 2 were able to achieve a higher output Po and a lower forward voltage Vf than the light emitting element in Reference Example. This is believed to be because the V pits 33 filled with the second layer 52 facilitated the light extraction from the lateral faces of the well layers 31. The light emitting element in Example 2 had a 21 mW lower output Po, but a 0.73 V lower forward voltage Vf than the light emitting element in Example 1. This is believed to be because the portion of the first layer 51 that was a composition gradient layer with a lower Al composition ratio reduced the forward voltage Vf, but the increased lower Al composition ratio portion of the first layer 51 increased the light absorption by the first layer 51 to reduce the output Po.

In the foregoing, certain embodiments of the present invention have been explained with reference to specific examples. The present invention, however, is not limited to these specific examples. All forms implementable by a person skilled in the art by suitably making design changes based on any of the embodiments of the present invention described above also fall within the scope of the present invention so long as they encompass the subject matter of the present invention defined by the appended claims. Furthermore, various modifications and alterations of the present invention that could have been made by a person skilled in the art and which are falling within the scope of the appended claims also form embodiments of the present invention.

## Claims

1. A light emitting element (1) comprising:
a semiconductor structure (100) comprising an n-side layer (20), a p-side layer (50), and an active layer (30) configured to emit ultraviolet light positioned between the n-side layer (20) and the p-side layer (50), each being made of a nitride semiconductor;
an n-electrode (60) electrically connected to the n-side layer (20); and
a p-electrode (70) electrically connected to the p-side layer (50), wherein:
the active layer (30) comprises a well layer (31) containing Al, a barrier layer (32) containing Al, and holes defined by lateral faces of the well layer (31) and lateral faces of the barrier layer (32),
the p-side layer (50) comprises a first layer (51) containing Al, a second layer (52) containing Al disposed on the first layer (51) and in contact with the lateral faces of the well layer (31), and a third layer (53) disposed on the second layer (52),
a thickness of the third layer (53) is less than a thickness of the first layer (51),
an Al composition ratio of the second layer (52) differs from an Al composition ratio of the well layer (31) by 10% or less,
an Al composition ratio of the third layer (53) is less than an Al composition ratio of the second layer (52), or the third layer (53) contains no Al, and
the p-electrode (70) is disposed on the third layer (53).

2. The light emitting element (1) according to claim 1, wherein the thickness of the third layer (53) is less than a thickness of the second layer (52).

3. The light emitting element (1) according to claim 1 or 2, wherein:
the first layer (51), the second layer (52), and the third layer (53) contain a p-type impurity, and
each of a p-type impurity concentration of the second layer (52) and a p-type impurity concentration of the third layer (53) is less than a p-type impurity concentration of the first layer (51).

4. The light emitting element (1) according to any one of claims 1 to 3, wherein the p-type impurity concentration of the third layer (53) is higher than the p-type impurity concentration of the second layer (52).

5. The light emitting element (1) according to any one of claims 1 to 4, wherein the p-type impurity concentration of the second layer (52) is in a range of 1×10¹⁹ cm³ to 1×10²¹ cm³.

6. The light emitting element (1) according to any one of claims 1 to 5, wherein an Al composition ratio of the first layer (51) is higher than the Al composition ratio of the second layer (52).

7. The light emitting element (1) according to any one of claims 1 to 6, wherein the Al composition ratio of the second layer (52) is higher the Al composition ratio of the well layer (31).

8. The light emitting element (1) according to any one of claims 1 to 7, wherein the Al composition ratio of the well layer (31) is 10% or higher.

9. The light emitting element (1) according to any one of claims 1 to 8, wherein a thickness of the second layer (52) is in a range of 3 nm to 20 nm.

10. The light emitting element (1) according to any one of claims 1 to 9, wherein:
the first layer (51) and the second layer (52) are made of aluminum gallium nitride, and
the third layer (53) is made of gallium nitride.

11. A method of manufacturing a light emitting element, the method comprising:
forming an n-side layer (20) made of a nitride semiconductor;
forming, on the n-side layer (20), an active layer (30) configured to emit ultraviolet light and comprising a well layer (31) containing Al and a barrier layer (32) containing Al, each being made of a nitride semiconductor, and holes defined by lateral faces of the well layer (31) and lateral faces of the barrier layer (32);
forming, on the active layer (30), a p-side layer (50) comprising a first layer (51) containing Al, a second layer (52) containing Al, and a third layer (53), each being made of a nitride semiconductor, wherein an Al composition ratio of the second layer (52) differs from an Al composition ratio of the well layer (31) by 10% or less, wherein a thickness of the third layer (53) is less than a thickness of the first layer (51), wherein an Al composition ratio of the third layer (53) is less than an Al composition ratio of the second layer (52), or the third layer (53) contains no Al, and wherein the step of forming the p-side layer (50) comprises:
forming the first layer (51) on the active layer (30),
forming the second layer (52) on the first layer (51) and in contact with the lateral faces of the well layer (31), and
forming the third layer (53) on the second layer (52);
forming an n-electrode (60) electrically connected to the n-side layer (20); and
forming a p-electrode (70) electrically connected to the third layer (53) of the p-side layer (50).

12. The method according to claim 11, wherein a growth rate at which the second layer (52) is formed is lower than a growth rate at which the first layer (51) is formed.

13. The method according to claim 11 or 12, wherein a growth rate at which the third layer (53) is formed is lower than a growth rate at which the first layer (51) is formed.

14. The method according to any one of claims 11 to 13, wherein:
in the step of forming a first layer (51), the first layer (51) is formed to contain a p-type impurity by using a p-type impurity gas, and
in the step of forming a second layer (52), the second layer (52) is formed to contain a p-type impurity by using a p-type impurity gas,
a p-type impurity gas flow ratio in the step of forming a second layer (52) is higher than a p-type impurity gas flow ratio in the step of forming a first layer (51).

15. The method according to any one of claims 11 to 13, wherein:
in the step of forming a first layer (51), the first layer (51) is formed to contain a p-type impurity by using a p-type impurity gas, and
in the step of forming a third layer (53), the third layer (53) is formed to contain a p-type impurity by using a p-type impurity gas,
a p-type impurity gas flow ratio in the step of forming a third layer (53) is higher than a p-type impurity gas flow ratio in the step of forming a first layer (51).

## Patentansprüche

1. Lichtemittierendes Element (1), umfassend:
eine Halbleiterstruktur (100), umfassend eine n-seitige Schicht (20), eine p-seitige Schicht (50) und eine aktive Schicht (30), die dazu konfiguriert ist, ultraviolettes Licht zu emittieren, die zwischen der n-seitigen Schicht (20) und der p-seitigen Schicht (50) positioniert ist, die jeweils aus einem Nitridhalbleiter gefertigt sind;
eine n-Elektrode (60), die mit der n-seitigen Schicht (20) elektrisch verbunden ist; und
eine p-Elektrode (70), die mit der p-seitigen Schicht (50) elektrisch verbunden ist, wobei:
die aktive Schicht (30) eine Topfschicht (31), die Al enthält, eine Barriereschicht (32), die Al enthält, und Löcher umfasst, die durch Seitenflächen der Topfschicht (31) und Seitenflächen der Barriereschicht (32) definiert sind,
die p-seitige Schicht (50) eine erste Schicht (51), die Al enthält, eine zweite Schicht (52), die Al enthält, die auf der ersten Schicht (51) angeordnet ist und in Kontakt mit den Seitenflächen der Topfschicht (31) ist, und eine dritte Schicht (53) umfasst, die auf der zweiten Schicht (52) angeordnet ist,
eine Dicke der dritten Schicht (53) geringer als eine Dicke der ersten Schicht (51) ist,
ein Al-Zusammensetzungsverhältnis der zweiten Schicht (52) sich von einem Al-Zusammensetzungsverhältnis der Topfschicht (31) um 10 % oder weniger unterscheidet,
ein Al-Zusammensetzungsverhältnis der dritten Schicht (53) geringer als ein Al-Zusammensetzungsverhältnis der zweiten Schicht (52) ist, oder die dritte Schicht (53) kein Al enthält, und
die p-Elektrode (70) auf der dritten Schicht (53) angeordnet ist.

2. Lichtemittierendes Element (1) nach Anspruch 1, wobei die Dicke der dritten Schicht (53) geringer als eine Dicke der zweiten Schicht (52) ist.

3. Lichtemittierendes Element (1) nach Anspruch 1 oder 2, wobei:
die erste Schicht (51), die zweite Schicht (52) und die dritte Schicht (53) eine p-Typ-Verunreinigung enthalten, und
jede von einer p-Typ-Verunreinigungskonzentration der zweiten Schicht (52) und einer p-Typ-Verunreinigungskonzentration der dritten Schicht (53) geringer als eine p-Typ-Verunreinigungskonzentration der ersten Schicht (51) ist.

4. Lichtemittierendes Element (1) nach einem der Ansprüche 1 bis 3, wobei die p-Typ-Verunreinigungskonzentration der dritten Schicht (53) höher als die p-Typ-Verunreinigungskonzentration der zweiten Schicht (52) ist.

5. Lichtemittierendes Element (1) nach einem der Ansprüche 1 bis 4, wobei die p-Typ-Verunreinigungskonzentration der zweiten Schicht (52) in einem Bereich von 1× 10¹⁹ cm³ bis 1×10²¹ cm³ liegt.

6. Lichtemittierendes Element (1) nach einem der Ansprüche 1 bis 5, wobei ein Al-Zusammensetzungsverhältnis der ersten Schicht (51) höher als das Al-Zusammensetzungsverhältnis der zweiten Schicht (52) ist.

7. Lichtemittierendes Element (1) nach einem der Ansprüche 1 bis 6, wobei das Al-Zusammensetzungsverhältnis der zweiten Schicht (52) höher als das Al-Zusammensetzungsverhältnis der Topfschicht (31) ist.

8. Lichtemittierendes Element (1) nach einem der Ansprüche 1 bis 7, wobei das Al-Zusammensetzungsverhältnis der Topfschicht (31) 10 % oder höher ist.

9. Lichtemittierendes Element (1) nach einem der Ansprüche 1 bis 8, wobei eine Dicke der zweiten Schicht (52) in einem Bereich von 3 nm bis 20 nm liegt.

10. Lichtemittierendes Element (1) nach einem der Ansprüche 1 bis 9, wobei:
die erste Schicht (51) und die zweite Schicht (52) aus Aluminiumgalliumnitrid gefertigt sind, und
die dritte Schicht (53) aus Galliumnitrid gefertigt ist.

11. Verfahren zum Herstellen eines lichtemittierenden Elements, wobei das Verfahren umfasst:
Bilden einer n-seitigen Schicht (20), die aus einem Nitridhalbleiter gefertigt ist;
Bilden, auf der n-seitigen Schicht (20), einer aktiven Schicht (30), die dazu konfiguriert ist, ultraviolettes Licht zu emittieren, und die eine Topfschicht (31), die Al enthält, und eine Barriereschicht (32), die Al enthält, die jeweils aus einem Nitridhalbleiter gefertigt sind, und Löcher umfasst, die durch Seitenflächen der Topfschicht (31) und Seitenflächen der Barriereschicht (32) definiert sind;
Bilden, auf der aktiven Schicht (30), einer p-seitigen Schicht (50), die eine erste Schicht (51), die Al enthält, eine zweite Schicht (52), die Al enthält, und eine dritte Schicht (53) umfasst, die jeweils aus einem Nitridhalbleiter gefertigt sind, wobei sich ein Al-Zusammensetzungsverhältnis der zweiten Schicht (52) von einem Al-Zusammensetzungsverhältnis der Topfschicht (31) um 10 % oder weniger unterscheidet, wobei eine Dicke der dritten Schicht (53) geringer als eine Dicke der ersten Schicht (51) ist, wobei ein Al-Zusammensetzungsverhältnis der dritten Schicht (53) geringer als ein Al-Zusammensetzungsverhältnis der zweiten Schicht (52) ist, oder die dritte Schicht (53) kein Al enthält, und wobei der Schritt des Bildens der p-seitigen Schicht (50) umfasst:
Bilden der ersten Schicht (51) auf der aktiven Schicht (30),
Bilden der zweiten Schicht (52) auf der ersten Schicht (51) und in Kontakt mit den Seitenflächen der Topfschicht (31), und
Bilden der dritten Schicht (53) auf der zweiten Schicht (52);
Bilden einer n-Elektrode (60), die mit der n-seitigen Schicht (20) elektrisch verbunden ist; und
Bilden einer p-Elektrode (70), die mit der dritten Schicht (53) der p-seitigen Schicht (50) elektrisch verbunden ist.

12. Verfahren nach Anspruch 11, wobei eine Wachstumsrate, mit der die zweite Schicht (52) gebildet wird, geringer als eine Wachstumsrate ist, mit der die erste Schicht (51) gebildet wird.

13. Verfahren nach Anspruch 11 oder 12, wobei eine Wachstumsrate, mit der die dritte Schicht (53) gebildet wird, geringer als eine Wachstumsrate ist, mit der die erste Schicht (51) gebildet wird.

14. Verfahren nach einem der Ansprüche 11 bis 13, wobei:
in dem Schritt des Bildens einer ersten Schicht (51) die erste Schicht (51) unter Verwendung eines p-Typ-Verunreinigungsgases dazu gebildet wird, eine p-Typ-Verunreinigung zu enthalten, und
in dem Schritt des Bildens einer zweiten Schicht (52) die zweite Schicht (52) unter Verwendung eines p-Typ-Verunreinigungsgases dazu gebildet wird, eine p-Typ-Verunreinigung zu enthalten,
ein p-Typ-Verunreinigungsgasflussverhältnis in dem Schritt des Bildens einer zweiten Schicht (52) höher als ein p-Typ-Verunreinigungsgasflussverhältnis in dem Schritt des Bildens einer ersten Schicht (51) ist.

15. Verfahren nach einem der Ansprüche 11 bis 13, wobei:
in dem Schritt des Bildens einer ersten Schicht (51) die erste Schicht (51) unter Verwendung eines p-Typ-Verunreinigungsgases dazu gebildet wird, eine p-Typ-Verunreinigung zu enthalten, und
in dem Schritt des Bildens einer dritten Schicht (53) die dritte Schicht (53) unter Verwendung eines p-Typ-Verunreinigungsgases dazu gebildet wird, eine p-Typ-Verunreinigung zu enthalten,
ein p-Typ-Verunreinigungsgasflussverhältnis in dem Schritt des Bildens einer dritten Schicht (53) höher als ein p-Typ-Verunreinigungsgasflussverhältnis in dem Schritt des Bildens einer ersten Schicht (51) ist.

## Revendications

1. Élément électroluminescent (1) comprenant :
une structure semi-conductrice (100) comprenant une couche côté n (20), une couche côté p (50) et une couche active (30) configurée pour émettre une lumière ultraviolette positionnée entre la couche côté n (20) et la couche côté p (50), chacune étant réalisée en un semi-conducteur au nitrure ;
une électrode n (60) reliée électriquement à la couche côté n (20) ; et
une électrode p (70) reliée électriquement à la couche côté p (50), dans lequel :
la couche active (30) comprend une couche de puits (31) contenant de l'Al, une couche barrière (32) contenant de l'Al, et des trous définis par des faces latérales de la couche de puits (31) et des faces latérales de la couche barrière (32),
la couche côté p (50) comprend une première couche (51) contenant de l'Al, une deuxième couche (52) contenant de l'Al disposée sur la première couche (51) et en contact avec les faces latérales de la couche de puits (31), et une troisième couche (53) disposée sur la deuxième couche (52),
une épaisseur de la troisième couche (53) est plus petite qu'une épaisseur de la première couche (51),
un rapport de composition d'Al de la deuxième couche (52) diffère d'un rapport de composition d'Al de la couche de puits (31) de 10 % ou moins,
un rapport de composition d'Al de la troisième couche (53) est inférieur à un rapport de composition d'Al de la deuxième couche (52), ou la troisième couche (53) ne contient pas d'Al, et
l'électrode p (70) est disposée sur la troisième couche (53).

2. Élément électroluminescent (1) selon la revendication 1, dans lequel l'épaisseur de la troisième couche (53) est plus petite qu'une épaisseur de la deuxième couche (52).

3. Élément électroluminescent (1) selon la revendication 1 ou 2, dans lequel :
la première couche (51), la deuxième couche (52) et la troisième couche (53) contiennent une impureté de type p, et
chacune d'une concentration en impureté de type p de la deuxième couche (52) et d'une concentration en impureté de type p de la troisième couche (53) est inférieure à une concentration en impureté de type p de la première couche (51).

4. Élément électroluminescent (1) selon l'une quelconque des revendications 1 à 3, dans lequel la concentration en impureté de type p de la troisième couche (53) est supérieure à la concentration en impureté de type p de la deuxième couche (52).

5. Élément électroluminescent (1) selon l'une quelconque des revendications 1 à 4, dans lequel la concentration en impureté de type p de la deuxième couche (52) est dans une plage allant de 1x10¹⁹ cm³ à 1x10²¹ cm³.

6. Élément électroluminescent (1) selon l'une quelconque des revendications 1 à 5, dans lequel un rapport de composition d'Al de la première couche (51) est supérieur au rapport de composition d'Al de la deuxième couche (52).

7. Élément électroluminescent (1) selon l'une quelconque des revendications 1 à 6, dans lequel le rapport de composition d'Al de la deuxième couche (52) est supérieur au rapport de composition d'Al de la couche de puits (31).

8. Élément électroluminescent (1) selon l'une quelconque des revendications 1 à 7, dans lequel le rapport de composition d'Al de la couche de puits (31) est de 10 % ou plus.

9. Élément électroluminescent (1) selon l'une quelconque des revendications 1 à 8, dans lequel une épaisseur de la deuxième couche (52) est dans une plage allant de 3 nm à 20 nm.

10. Élément électroluminescent (1) selon l'une quelconque des revendications 1 à 9, dans lequel :
la première couche (51) et la deuxième couche (52) sont réalisées en nitrure d'aluminium et de gallium, et
la troisième couche (53) est réalisée en nitrure de gallium.

11. Procédé de fabrication d'un élément électroluminescent, le procédé comprenant :
la formation d'une couche côté n (20) réalisée en un semi-conducteur au nitrure ;
la formation, sur la couche côté n (20), d'une couche active (30) configurée pour émettre une lumière ultraviolette et comprenant une couche de puits (31) contenant de l'Al et une couche barrière (32) contenant de l'Al, chacune étant réalisée en un semi-conducteur au nitrure, et des trous définis par des faces latérales de la couche de puits (31) et des faces latérales de la couche barrière (32) ;
la formation, sur la couche active (30), d'une couche côté p (50) comprenant une première couche (51) contenant de l'Al, une deuxième couche (52) contenant de l'Al et une troisième couche (53), chacune étant réalisée en un semi-conducteur au nitrure, dans lequel un rapport de composition d'Al de la deuxième couche (52) diffère d'un rapport de composition d'Al de la couche de puits (31) de 10 % ou moins, dans lequel une épaisseur de la troisième couche (53) est plus petite qu'une épaisseur de la première couche (51), dans lequel un rapport de composition d'Al de la troisième couche (53) est inférieur à un rapport de composition d'Al de la deuxième couche (52), ou la troisième couche (53) ne contient pas d'AI, et dans lequel l'étape de formation de la couche côté p (50) comprend :
la formation de la première couche (51) sur la couche active (30),
la formation de la deuxième couche (52) sur la première couche (51) et en contact avec les faces latérales de la couche de puits (31), et
la formation de la troisième couche (53) sur la deuxième couche (52) ;
la formation d'une électrode n (60) reliée électriquement à la couche côté n (20) ; et
la formation d'une électrode p (70) reliée électriquement à la troisième couche (53) de la couche côté p (50).

12. Procédé selon la revendication 11, dans lequel un taux de croissance selon lequel la deuxième couche (52) est formée est inférieur à un taux de croissance selon lequel la première couche (51) est formée.

13. Procédé selon la revendication 11 ou 12, dans lequel un taux de croissance selon lequel la troisième couche (53) est formée est inférieur à un taux de croissance selon lequel la première couche (51) est formée.

14. Procédé selon l'une quelconque des revendications 11 à 13, dans lequel :
lors de l'étape de formation d'une première couche (51), la première couche (51) est formée de façon à contenir une impureté de type p en utilisant un gaz d'impureté de type p, et
lors de l'étape de formation d'une deuxième couche (52), la deuxième couche (52) est formée de façon à contenir une impureté de type p en utilisant un gaz d'impureté de type p,
un rapport de débit de gaz d'impureté de type p lors de l'étape de formation d'une deuxième couche (52) est supérieur à un rapport de débit de gaz d'impureté de type p lors de l'étape de formation d'une première couche (51).

15. Procédé selon l'une quelconque des revendications 11 à 13, dans lequel :
lors de l'étape de formation d'une première couche (51), la première couche (51) est formée de façon à contenir une impureté de type p en utilisant un gaz d'impureté de type p, et
lors de l'étape de formation d'une troisième couche (53), la troisième couche (53) est formée de façon à contenir une impureté de type p en utilisant un gaz d'impureté de type p,
un rapport de débit de gaz d'impureté de type p lors de l'étape de formation d'une troisième couche (53) est supérieur à un rapport de débit de gaz d'impureté de type p lors de l'étape de formation d'une première couche (51).
